# EUROPÄISCHE PATENTSCHRIFT

(11) **EP 0 783 174 B1**
(45) Veröffentlichungstag und Bekanntmachung des Hinweises auf die Patenterteilung: **13.12.2006**
(21) Anmeldenummer: 96112420.3
(22) Anmeldetag: 01.08.1996
(51) Int. Cl.: H01J 37/34, C23C 14/40, C23C 14/35, C23C 14/00, C23C 14/56, C23C 16/50, H01J 37/32

(54) **Vorrichtung zum Beschichten eines Substrats**
Apparatus for coating a substrate
Dispositif pour le revêtement d'un substrat

(30) Priorität: 27.10.1995 DE 19540053; 28.10.1995 DE 19540255
(43) Veröffentlichungstag der Anmeldung: 09.07.1997
(73) Patentinhaber: Applied Materials GmbH & Co. KG, 63755 Alzenau (DE)
(72) Erfinder: Szczyrbowski, Joachim, Dr., 63773 Goldbach (DE); Teschner, Götz, 63450 Hanau (DE); Zmelty, Anton, 63768 Hösbach (DE)
(74) Vertreter: GROSSE BOCKHORNI SCHUMACHER

(56) Entgegenhaltungen:
- EP-A- 0 502 242
- EP-A- 0 510 401
- EP-A- 0 544 107
- DE-A- 4 237 517
- DE-A- 4 239 843
- DE-A- 4 326 100

## Beschreibung

Die Erfindung betrifft eine Vorrichtung zum Beschichten eines Substrats, bestehend aus einer Wechselstromquelle, die mit Magnete einschließende Kathoden verbunden ist, die elektrisch mit den Targets zusammenwirken, die zerstäubt werden und deren zerstäubte Teilchen sich auf dem Substrat niederschlagen.

Es ist bereits eine Zerstäubungseinrichtung zur Herstellung dünner Schichten bekannt (DD 252 205), bestehend aus einem Magnetsystem und mindestens zwei darüber angeordneten Elektroden aus dem zu zerstäubenden Material, wobei diese Elektroden elektrisch so gestaltet sind, daß sie wechselweise Kathode und Anode einer Gasentladung sind. Die Elektroden sind zu diesem Zwecke an eine sinusförmige wechselspannung von vorzugweise 50 Hz angeschlossen.

Diese bekannte Zerstäubungseinrichtung soll besonders für die Abscheidung dielektrischer Schichten durch reaktive Zerstäubung geeignet sein. Durch den Betrieb der Einrichtung mit etwa 50 Hz soll vermieden werden, daß es zur Flitterbildung an der Anode und im Falle von Metallbeschichtung zu elektrischen Kurzschlüssen (sogenannten Arcs) kommt.

Bei einer anderen bereits bekannten Vorrichtung zum Aufstäuben eines dünnen Films, bei der die Geschwindigkeit des Niederbringens von Schichten unterschiedlicher Materialien regelbar ist (DE 39 12 572), um so zu extrem dünnen Schichtpaketen zu gelangen, sind mindestens zwei unterschiedliche Arten von kathodenseitig vorgesehenen Gegenelektroden angeordnet.

Weiterhin ist eine Anordnung zum Abscheiden einer Metalllegierung mit Hilfe von HF-Kathodenzerstäubung bekannt (DE 35 41 621), bei der abwechselnd zwei Targets angesteuert werden, wobei die Targets die Metallkomponenten der abzuscheidenden Metallegierung jedoch mit unterschiedlichen Anteilen enthalten. Die Substrate sind zu diesem Zweck auf einem Substratträger angeordnet, der von einer Antriebseinheit während des Zerstäubungsvorgangs in Rotation versetzt wird.

Durch eine vorveröffentlichte Druckschrift (DE 38 02 852) ist es außerdem bekannt, bei einer Einrichtung für die Beschichtung eines Substrats mit zwei Elektroden und wenigstens einem zu zerstäubenden Material das zu beschichtende Substrat zwischen den beiden Elektroden in einem räumlichen Abstand anzuordnen und die Wechselstrom-Halbwellen als niederfrequente Halbwellen mit im wesentlichen gleichen Amplituden zu wählen. '

Weiterhin sind ein Verfahren und eine Vorrichtung beschrieben (DOS 42 37 517 und DOS 41 06 770) zum reaktiven Beschichten eines Substrats mit einem elektrisch isolierenden Werkstoff, beispielsweise mit Siliziumdioxid (SiO₂), bestehend aus einer Wechselstromquelle, die mit in einer Beschichtungskammer angeordneten Magnete einschließende Kathoden verbunden ist, die mit Targets zusammenwirken, wobei zwei erdfreie Ausgänge der Wechselstromquelle mit je einer ein Target tragenden Kathode verbunden sind, wobei beide Kathoden in der Beschichtungskammer nebeneinanderliegend in einem Plasmaraum vorgesehen sind und zum gegenüberliegenden Substrat jeweils etwa den gleichen räumlichen Abstand aufweisen. Der Effektivwert der Entladespannung wird dabei von einer über eine Leitung an die Kathode angeschlossenen Spannungseffektivwerterfassung gemessen und als Gleichspannung einem Regler über eine Leitung zugeführt, der über ein Regelventil den Reaktivgasfluß vom Behälter in die Verteilerleitung so steuert, daß die gemessene Spannung mit einer Sollspannung übereinstimmt.

Schließlich ist eine Vorrichtung zum Beschichten eines Substrats, insbesondere mit nichtleitenden Schichten von elektrisch leitfähigen Targets in reaktiver Atmosphäre bekannt (DE 42 04 999), bestehend aus einer Stromquelle, die mit in einer evakuierbaren Beschichtungskammer angeordneten, Magnete einschließenden Kathoden verbunden ist, die elektrisch mit den Targets zusammenwirken, wobei zwei elektrisch voneinander und von der Sputterkammer getrennte Anoden angeordnet sind, die in einer Ebene zwischen den Kathoden und dem Substrat vorgesehen sind, wobei die beiden Ausgänge der Sekundärwicklung eines mit einem Mittelfrequenzgenerator verbundenen Transformators jeweils an eine Kathode über Versorgungsleitungen angeschlossen sind, wobei die erste und die zweite Versorgungsleitung über eine Zweigleitung untereinander verbunden sind, in die ein Schwingkreis, vorzugsweise eine Spule und ein Kondensator, eingeschaltet sind, und wobei jede der beiden Versorgungsleitungen jeweils sowohl über ein das Gleichspannungspotential gegenüber Erde einstellendes erstes elektrisches Glied mit der Beschichtungskammer als auch über ein entsprechendes zweites elektrisches Glied mit der jeweiligen Anode und über jeweils eine Zweigleitung mit eingeschaltetem Kondensator mit der Beschichtungskammer verbunden ist und wobei eine Drosselspule in den den Schwingkreis mit dem zweiten Sekundäranschluß verbundenen Abschnitt der ersten Versorgungsleitung eingeschaltet ist.

Während die bekannten Vorrichtungen sich damit befassen, das "Arcing", d.h. die Bildung unerwünschter Lichtbögen zu verhindern und die Oberfläche der Targets vor der Bildung isolierender Schichten zu bewahren, soll der Gegenstand der vorliegenden Erfindung nicht nur die Stabilität des Sputterprozesses erhöhen, sondern auch die Schichtdikkengleichmäßigkeit steuerbar machen. Darüber hinaus soll die Vorrichtung nach einer besonderen Ausführungsform auch extrem rasch konditionierbar sein, wozu die inneren Flächen der Kammern, Einbauten und Targets von der Wasserbenutzung zu befreien sind.

Gemäß der vorliegenden Erfindung wird diese Aufgabe dadurch gelöst, daß die beiden Ausgänge der Wechselstromquelle jeweils an eine Kathode über Versorgungsleitungen angeschlossen sind, wobei jede der beiden Kathoden in einem eigenen Abteil einer Vielzahl von benachbarten, zusammen eine Vakuumkammer bildenden, über einen Durchgang miteinander verbundenen Abteilen angeordnet ist und die beiden die Kathoden aufweisenden Abteile unmittelbar nebeneinander angeordnet oder durch ein oder mehrere Abteile voneinander abgetrennt, vorgesehen sind.

Bei einer besonderen Ausführungsform ist der eine Pol der Wechselstromquelle an die eine Kathode und der andere Pol an die andere Kathode über Versorgungsleitungen angeschlossen, wobei jede der beiden Kathoden in einem eigenen Abteil einer Vielzahl von benachbarten, zusammen eine Vakuumkammer bildenden, über einen Durchgang miteinander verbundenen Abteilen vorgesehen ist, wobei die beiden, die mit der Wechselstromquelle verbundenen Kathoden aufweisenden Abteile durch ein oder mehrere Abteile, die zumindest teilweise mit je einer Sputterkathode ausgestattet sind, voneinander abgetrennt, vorgesehen sind.

Weitere Einzelheiten und Merkmale sind in den Patentansprüchen näher erläutert und gekennzeichnet.

Die Erfindung läßt die verschiedensten Ausführungsmöglichkeiten zu; zwei davon sind in den anliegenden Zeichnungen, rein schematisch näher dargestellt und zwar zeigen:
- Fig. 1: eine Vorrichtung mit einer Vielzahl von hintereinander angeordneten Abteilen, wobei die mit der Wechselstromquelle verbundenen Kathoden im ersten und letzten der zeichnerisch dargestellten Abteile vorgesehen sind und
- Fig. 2: eine Vorrichtung ähnlich derjenigen nach Fig. 1, wobei jedoch die Abteile, die zwischen den beiden, die mit der Wechselstromquelle verbundenen Kathoden enthaltenen Abteilen angeordnet sind, teilweise mit einer eigenen Sputterkathode ausgerüstet sind.

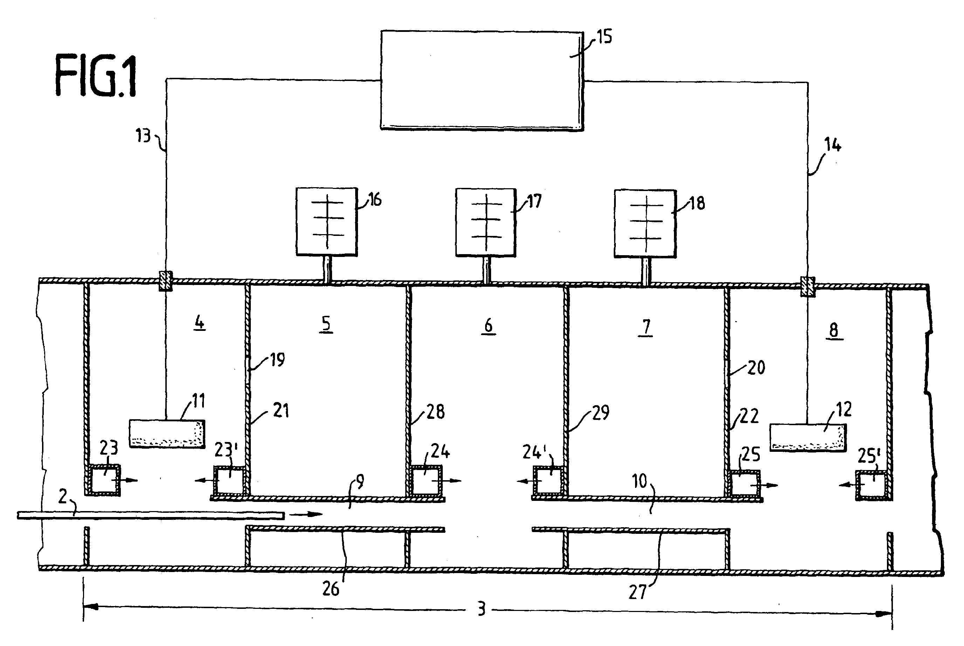

Die Vorrichtung besteht nach Fig. 1 aus einer Vakuum-Haupt-kammer 3, die in eine Vielzahl von einzelnen Abteilen 4 bis 8 aufgeteilt ist, wobei alle Abteile über einen zumindest abschnittsweise mit Hilfe von Rohren oder Schächten 26, 27 gebildeten Durchgang 9 bzw. 10 untereinander in Verbindung stehen und das erste und das letzte der Abteile 1 bzw. 8 jeweils mit einer Kathode 11,12 ausgestattet ist, wobei die beiden Kathoden 11,12 über Versorgungsleitungen 13,14 mit der Wechselstromquelle 15, beispielsweise einem Mittelfrequenz-Generator, verbunden sind. Das zweite, dritte und vierte Abteil 5,6 bzw. 7 ist jeweils an eine eigene Vakuumpumpe 16,17,18 angeschlossen, wobei die ersten beiden Abteile 7 und 8 untereinander über Öffnungen 19 bzw. 20 in den jeweiligen Trennwänden 21 bzw. 22 verbunden sind. Die Abteile 4,6 und 8 sind an Gaszufuhrleitungen 23,23' bzw. 24,24' bzw. 25,25' angeschlossen, über die Prozeßgas in die einzelnen Abteile 4 bis 8 eingelassen werden kann. Das Substrat 2 wird während des Beschichtungsvorgangs entlang dem Durchgang 9,10 bzw. durch die Rohre oder Schächte 26,27 transportiert und an den beiden Kathoden 11,12 vorbei bewegt, wobei die einzelnen Abteilungen 4 bis 8 eine feinfühlige Einstellung der Sputterbedingungen für die beiden Kathoden 11,12 gestatten.

Die Kathoden 11, 12, die beide zusammen von einem Wechselstromgenerator gespeist werden, sind in den Abteilen 4, 8 angeordnet, die jeweils über Öffnungen 19, 20 mit den benachbarten Abteilen 5,7 verbunden sind, über die die Kathoden-Abteile 4,8 evakuiert werden. Die Gas-Einlässe 23,23' bzw. 25,25' versorgen die Kathoden mit Prozeßgas, z.B. Argon. Der Gaseinlaß 24,24' versorgt die Kathoden mit Reaktivgas.

Die vorstehend beschriebene und in Fig. 1 dargestellte Vorrichtung hat insbesondere folgende Vorteile:
1. Vereinfachung einer Zwei-Magnetron-Kathoden-Vorrichtung dadurch, daß zwei Standard-Kathoden 11,12 hoher Leistung in separaten Compartments bzw. Abteilen 4,8 verwendet werden können.
2. Da die Abteile voneinander getrennt sind, können die Kathoden 11,12 in verschiedenen Sputteratmosphären betrieben werden.
3. Durch 2. ist es möglich, die Arbeitspunkte der beiden Kathoden 11,12 getrennt einzustellen, zu steuern und zu regeln.
4. Es ist möglich, die Kathoden 11,12 in metallischem Mode zu betreiben, d.h. ohne oder mit wenig Reaktivgas, wobei das Reaktivgas in ein Abteil zwischen den Kathoden eingelassen wird. In diesem Abteil kann das abgeschiedene Material mit dem Reaktivgas unter Plasmaeinwirkung reagieren.
5. Durch das Auseinanderrücken der Kathoden 11,12 wird zwischen den beiden Kathoden eine Plasmazone sehr großer Ausdehnung erzeugt. Ohne daß zusätzliche Hilfsmittel benötigt werden, kann ein Plasmaband von mehreren Metern Länge mit der Breite der Kathoden erzeugt werden. In diesem Plasmaband können Substrate 2 behandelt werden (Ätzen Nitrieren, Aktivieren der Oberfläche ...).
6. Durch den großen Abstand zwischen den beiden Kathoden 11,12 wird ein direkter Überschlag erschwert. Damit wird die Stabilität des Prozesses erhöht.
7. Auf dem Weg zwischen den beiden Kathoden 11,12 sind Druckstufen 5,6,7 angeordnet; die es gestatten, daß die Sputtergasdrücke in den beiden Kathodenräumen 4 und 8 und auch im Zwischenraum 6 zwischen den Kathoden 11,12 jeweils unterschiedlich eingestellt werden können.
8. Durch die Druckstufen nach 7. ist es auch möglich, die Kathoden 11,12 mit unterschiedlichen Gasarten oder -mischungen zu betreiben.
9. Die Öffnung bzw. der Schacht 26,27 bzw. der Durchgang 9,10 ermöglicht den Transport des Substrats 2, wobei der Substrattransport auch durch Spaltschleusen vom Plasma getrennt vorgenommen werden kann.
10. Die Vorrichtung ist geeignet, um großflächiges PECVD durchzuführen. Auch beim großflächigen Plasmabehandeln bietet diese Vorrichtung Vorteile, d.h. beim Ätzen und Entgasen von eingeschleusten Substraten. Schließlich ist das Entgasen einer Standard-Glasanlage auf diese Weise denkbar, indem zwischen der ersten und der letzten DC-Kathode der Gesamtanlage oder zwischen zusätzlichen Kathoden vorzugsweise mit Ti-Target während des Anpumpens ein Mittelfrequenzplasma gezündet wird.

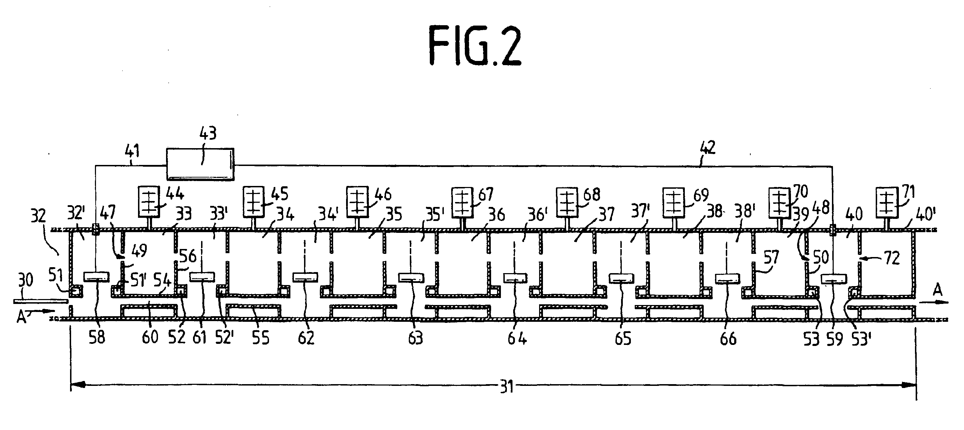

Die Vorrichtung gemäß Fig. 2 besteht aus einer Vakuum-Haupt-kammer 31, die in eine Vielzahl von einzelnen Abteilen 31 bis 40, 32' bis 40' aufgeteilt ist, wobei alle Abteile über einen zumindest abschnittsweise mit Hilfe von Rohren oder Schächten 54, 55, ... gebildeten Durchgang 60 untereinander in Verbindung stehen und das erste und das vorletzte der Abteile 32 bzw. 40 jeweils mit einer Kathode 58, 59 ausgestattet ist, wobei die beiden Kathoden 58, 59 über Versorgungsleitungen 41, 42 mit den Polen der Wechselstromquelle 43, beispielsweise einem Mittelfrequenz-Generator, verbunden sind. Das zweite, vierte, sechste usw. Abteil 33 bis 39 und 40' ist jeweils an eine eigene Vakuumpumpe 44, 45, 46 bzw. 67 bis 71 angeschlossen, wobei die Abteile 32' bis 40' untereinander über Öffnungen 47, 48, ... in den jeweiligen Trennwänden 49, 50, ... verbunden sind. Die Abteile 32', 33' bis 38', 40 sind an Gaszufuhrleitungen 51, 51'; 52, 52'; 53, 53'; ... angeschlossen, über die Prozeßgas in die einzelnen Abteile 32', 33' bis 38' und 40 eingelassen werden kann. Das Substrat 30 (z.B. eine Flachglasscheibe) wird während des Beschichtungsvorgangs entlang dem Durchgang 60 durch die Rohre oder Schächte 54, 55, ... transportiert und an den beiden Kathoden 58, 59 vorbei bewegt, wobei die einzelnen Abteilungen eine feinfühlige Einstellung der Sputterbedingungen für die beiden Kathoden 58, 59 gestatten.

Die Kathoden 58, 59, die beide zusammen von einem Wechselstromgenerator 43 gespeist werden, sind in den Abteilen 32', 40 angeordnet, die jeweils über Öffnungen 47, 48, 72 mit den benachbarten Abteilen 33, 39 und 40' verbunden sind, über die die Kathoden-Abteile 31', 40 evakuiert werden. Die Gas-Einlässe 51, 51' bzw. 53, 53' versorgen die Kathoden 58, 59 mit Prozeßgas, z.B. Argon.

Die in den Abteilen 33', 34' bis 38' angeordneten Kathoden 61 bis 66 sind mit in der Zeichnung nicht näher dargestellten Stromquellen verbunden und können sowohl mit Gleichstrom, als auch mit Wechselstrom, beispielsweise mit Mittelfrequenz, betriebene Sputterkathoden sein.

Im dargestellten Falle handelt es sich um das Schema einer Flachglas-Beschichtungsanlage, bei der die Glasscheibe 30 von links kommend in Pfeilrichtung A alle Stationen durchläuft bzw. alle Abteile passiert und am rechten Ende des Durchgangs 60 in Pfeilrichtung A wieder austritt. Die Kathoden 61 bis 66 dienen in diesem Falle ausschließlich der Glasbeschichtung, während die mit Wechselstrom versorgten Kathoden 58 und 59 für die Konditionierung der Durchlaufanlage Sorge tragen und während des eigentlichen Beschichtungsvorgangs ausgeschaltete bleiben.

Glasbeschichtungsanlagen benötigen im allgemeinen etwa 8 bis 10 Stunden zur Konditionierung. Diese Zeit geht daher der Produktion verloren. Standard-Glimmeinrichtungen zur Verstärkung der Desorption haben sich nicht durchsetzen können, da sie in dem Raum, in dem während des Betriebes eine starke Verschmutzung eintritt, zusätzliche Elektroden benötigen. Diese erzeugen dann Flitter und andere Abplatzungen.

Vorteil der vorgeschlagenen Anordnung ist es, daß in den Räumen, in denen die Desorption verstärkt werden soll, keine zusätzlichen Einbauten erforderlich sind. Hinzu kommt, daß das Plasma hauptsächlich im Bereich zwischen der Transporteinrichtung und dem Anlagenboden brennt, so daß auch die Bereiche erfaßt werden, die sich den normalen Reinigungszyklen entziehen.

Durch das intensive Magnetronplasma wird eine starke Desorption an allen inneren Oberflächen der Beschichtungsanlage bewirkt. Das Magnetronplasma hat eine um den Faktor 10 größere Ladungsträgerdichte gegenüber den bekannten DC-Glimmreinigungsplasmen. Die für DC typische Einschnürung des Plasmas tritt bei der Mittelfrequenz nicht auf. Das Plasma erfüllt die ganze Kammer 31. In dieser Anordnung eine DC-Magnetronentladung zu zünden, ist technisch ohne weitere Hilfsmittel nicht möglich. Die Mittelfrequenzentladung zündet demgegenüber problemlos.

Bei der DC-Entladung treten weitere Probleme dadurch auf, daß die Kathode eine Anode benötigt, so daß entweder eine zusätzliche Elektrode eingebaut werden muß, oder daß die Gettersputterstrecke nur einseitig in der Anlage angeordnet ist.

Die Zeichnung zeigt den typischen Aufbau einer Glasbeschichtungsanlage mit mehreren Kathoden, die jeweils in einem gesonderten Abteil angeordnet sind. Zu jeder Kathode gehört ein Gaseinlaß- und -verteilungssystem. Die Kathodenabteile werden durch die jeweils benachbarten Pumpabteile 33 bis 39, 40' evakuiert. Fig. 2 zeigt eine Variante, bei der die erste und die letzte Kathode 58, 59 der Anlage für die Plasmaerzeugung an den Mittelfrequenzgenerator 15 angeschlossen sind. Dazu sind sie von den zugehörigen DC-Stromver-sorgungen (nicht dargestellt) getrennt. Wird nun die Mittelfrequenzspannung an die Kathoden 58, 59 angelegt, so bildet sich ein Plasmaband durch die gesamte Anlage. Mit den Gaseinlässen der Kathoden, die sich zwischen den beiden mit Mittelfrequenz gespeisten Kathoden befinden, kann die Plasmaintensität in den Kammern variiert werden. Zum Konditionieren besputtern die Kathoden 58, 59 das Bodenteil des Kammer 31; es ist jedoch durchaus sinnvoll, Substrate unterhalb der beiden Kathoden 30,31 anzuordnen, die später entfernt werden, um eine unnötige Beschichtung dieses Bodenteils zu verhindern. Als Target für die Kathoden 58, 59 empfiehlt sich ein Titan-Target.

### Bezugszeichenliste

- 2: Substrat
- 3: Vakuum-Hauptkammer
- 4: Abteilung
- 5: Abteilung
- 6: Abteilung
- 7: Abteilung
- 8: Abteilung
- 9: Durchgang
- 10: Durchgang
- 11: Sputterkathode
- 12: Sputterkathode
- 13: Versorgungsleitung
- 14: Versorgungsleitung
- 15: Wechselstromquelle
- 16: Vakuumpumpe
- 17: Vakuumpumpe
- 18: Vakuumpumpe
- 19: Öffnung
- 20: Öffnung
- 21: Trennwand
- 22: Trennwand
- 23,23': Gaszufuhrleitung
- 24,24': Gaszufuhrleitung
- 25,25': Gaszufuhrleitung
- 26: Rohrschacht
- 27: Rohrschacht
- 28: Trennwand
- 29: Trennwand
- 30: Substrat, Glasscheibe
- 31: Vakuum-Hauptkammer
- 32, 32': Abteilung
- 33, 33': Abteilung
- 34, 34': Abteilung
- 35, 35': Abteilung
- 36, 36': Abteilung
- 37, 37': Abteilung
- 38, 38': Abteilung
- 39, 39': Abteilung
- 40, 40': Abteilung
- 41: Versorgungsleitung
- 42: Versorgungsleitung
- 43: Wechselstromquelle
- 44: Vakuumpumpe
- 45: Vakuumpumpe
- 46: Vakuumpumpe
- 47: Öffnung
- 48: Öffnung
- 49: Trennwand
- 50: Trennwand
- 51, 51': Gaszufuhrleitung
- 52, 52': Gaszufuhrleitung
- 53, 53': Gaszufuhrleitung
- 54: Rohrschacht
- 55: Rohrschacht
- 56: Trennwand
- 57: Trennwand
- 58: Kathode
- 59: Kathode
- 60: Durchgang
- 61: Kathode
- 62: Kathode
- 63: Kathode
- 64: Kathode
- 65: Kathode
- 66: Kathode
- 67: Vakuumpumpe
- 68: Vakuumpumpe
- 69: Vakuumpumpe
- 70: Vakuumpumpe
- 71: Vakuumpumpe
- 72: Öffnung

## Patentansprüche

1. Vorrichtung zum Beschichten eines Substrats, (2), insbesondere mit nichtleitenden Schichten von elektrisch leitfähigen Targets in reaktiver (z.B. oxydierender) Atmosphäre, bestehend aus einer Wechselstromquelle (15), die mit zwei Magnete einschließenden Kathoden (11,12) verbunden ist, die elektrisch mit den Targets zusammenwirken, die zerstäubt werden und deren abgestäubte Teilchen sich auf dem Substrat (2) niederschlagen, wobei der eine Pol der Wechselstromquelle (15) an die eine Kathode (11) und der andere Pol an die andere Kathode (12) über Versorgungsleitungen (13,14) angeschlossen ist, **dadurch gekennzeichnet, daß** jede der beiden Kathoden (11,12) in einem eigenen Abteil (4,8) einer Vielzahl von benachbart angeordneten, zusammen eine Vakuumkammer (3) bildenden, über einen Durchgang (9) miteinander verbundenen Abteilen (4 bis 8) vorgesehen ist, wobei die beiden die Kathoden (11,12) aufweisenden Abteile (4,8) unmittelbar nebeneinander angeordnet oder durch ein oder mehrere Abteile (5,6,7) voneinander abgetrennt, vorgesehen sind.

2. Vorrichtung nach Anspruch 1, **dadurch gekennzeichnet, daß** des erste und das letzte Abteil (4 bzw. 8) von in einer Reihe nebeneinanderliegenden Abteilen (4 bis 8) jeweils mit einer Kathode (11 bzw. 12) ausgestattet sind, wobei in beide Abteile (4,8) zusätzlich Gasleitungen einmünden, über die ein Prozeßgas in diese Abteile einleitbar ist.

3. Vorrichtung nach Anspruch 1, **dadurch gekennzeichnet, daß** der Durchgang (9 bzw. 10) für den Transport der Substrate (2) durch die Kathodenstationen (4 und 8) partiell über in einer Flucht angeordnete Rohre oder Schächte (26,27) erfolgt, die durch einzelne Abteilungen voneinander abtrennende Wände (21,28 bzw. 22,29) dichtend hindurchgeführt sind, wobei die Abteile (5 bzw. 7) durch die die Rohre oder Schächte (26,27) hindurchragen, über Durchbrüche oder Öffnungen (19 bzw. 20) in den Trennwänden (21 bzw. 22) mit den Abteilen (4,8) für die Kathoden (11,12) korrespondieren.

4. Vorrichtung nach einem oder mehreren der Ansprüche 1 bis 3, **dadurch gekennzeichnet, daß** in die mit den Kathoden (11,12) ausgestatteten Abteile (4,8) Leitungen (23,23' bzw. 25,25') einmünden, über die Argon in diese Abteile (4,8) einlaßbar ist, wobei in ein zwischen den beiden Kathoden-Abteilen (4,8) angeordnetes drittes Abteil (6) weitere Leitungen (24,24') einmünden, über die ein Reaktivgas einlaßbar ist.

5. Vorrichtung nach einem oder mehreren der Ansprüche 1 bis 4, **dadurch gekennzeichnet, daß** die zwischen den beiden mit Kathoden (11,12) versehenen Abteilen (4,8) angeordneten Abteile (5,6,7) jeweils mit Vakuumpumpen (16,17,18) verbunden sind.

6. Vorrichtung zum Beschichten eines Substrats (30), bestehend aus einer Wechselstromquelle (43), die mit zwei Magnete einschließende Kathoden (58, 59) verbunden ist, die elektrisch mit den Targets zusammenwirken, wobei der eine Pol der Wechselstromquelle (43) an die eine Kathode (58) und der andere Pol an die andere Kathode (59) über Versorgungsleitungen (41, 42) angeschlossen ist, **dadurch gekennzeichnet, daß** jede der beiden Kathoden (58, 59) in einem eigenen Abteil (32', 40) einer Vielzahl von benachbart angeordneten, zusammen eine Vakuumkammer (31) bildenden, über einen Durchgang (60) miteinander verbundenen Abteilen (32 bis 40') vorgesehen ist, wobei die beiden die mit der Wechselstromquelle (43) verbundenen Kathoden (58, 59) aufweisenden Abteile (32', 40) durch ein oder mehrere Abteile (33 bis 39 und 33' bis 38'), die zumindest teilweise mit je einer Sputterkathode (61 bis 66) ausgestattet sind, voneinander abgetrennt, angeordnet sind.

7. Vorrichtung nach Anspruch 6, **dadurch gekennzeichnet, daß** das erste und das letzte Abteil (32' bzw. 40) von in einer Reihe nebeneinanderliegenden Abteilen (32' bis 40') jeweils mit einer Kathode (58 bzw. 59) ausgestattet sind, wobei in beide Abteile (32', 40) zusätzlich Gasleitungen (51, 51' bzw. 53, 53') einmünden, über die ein Prozeßgas in diese Abteile (32', 40) einleitbar ist.

8. Vorrichtung nach Anspruch 6, **dadurch gekennzeichnet, daß** der Durchgang (60) für den Transport der Substrate (30) durch die Kathodenstationen (32' und 40), deren Kathoden mit der Wechselstromquelle (43) verbunden sind, partiell über in einer Flucht angeordnete Rohre oder Schächte (54, 55, usw.) erfolgt, die durch einzelne, die Abteile voneinander abtrennende Wände (49, 56 bzw. 50, 57 usw.) dichtend hindurchgeführt sind, wobei die Abteile (33 bzw. 40') durch die die Rohre oder Schächte (54, 55, ...) hindurchragen, über Durchbrüche oder Öffnungen (47, 48, usw.) in den Trennwänden (49, 50, usw.) mit den Abteilen (32', 40) für die Kathoden (58, 59) korrespondieren.

9. Vorrichtung nach den Ansprüchen 1 bis 3, **dadurch gekennzeichnet, daß** neben den Abteilen (32' 40) für die beiden an den Generator (43) angeschlossenen Kathoden (58, 59) weitere Abteile (33' bis 38') vorgesehen sind, in denen Sputterkathoden (61 bis 66) angeordnet sind, die mit einer zweiten Stromquelle verbunden sind, wobei diese Kathoden (61 bis 66) aufweisenden Abteile (33' bis 38') zum Durchgang (60) für das Substrat (30 hin offen sind und das Substrat (30) beim Transport durch den Durchgang (60) in den Wirkungsbereich aller dieser Kathoden (61 bis 66) gelangt.

## Claims

1. Apparatus for coating a substrate (2), especially with non-conductive layers from electrically conductive targets in a reactive (e.g. oxidising) atmosphere, said apparatus comprising an alternating current source (15) which is connected to two cathodes (11,12) which enclose magnets and cooperate electrically with the targets which are being sputtered and the sputtered particles of which are deposited on the substrate (2), the one pole of the alternating current source (15) being connected to the one cathode (11) and the other pole to the other cathode (12) via power supply lines (13, 14), **characterised in that** each of the two cathodes (11, 12) is provided in its own compartment (4, 8) of a large number of adjacent compartments (4 to 8) which together form a vacuum chamber (3) and which are interconnected via a passageway (9), the two compartments (4, 8) having the cathodes (11, 12) being provided arranged directly beside one another or separated from each other by one or more compartments (5, 6, 7).

2. Apparatus according to claim 1, **characterised in that** the first and the last compartments (4 or 8) of compartments (4 to 8) located beside one another in a row are each equipped with a cathode (11 or 12) and, additionally, opening into the two compartments (4, 8) are gas feed lines via which a process gas can be led into these compartments.

3. Apparatus according to claim 1, **characterised in that** the passageway (9 or 10) for the conveyance of the substrates (2) through the cathode stations (4 and 8) is provided partially via pipes or shafts (26, 27) which are arranged in alignment and which are guided in a sealing manner through individual walls (21, 28 or 22, 29) separating compartments from each other, the compartments (5 or 7) through which the pipes or shafts (26, 27) protrude corresponding via apertures or openings (19 or 20) in the partition walls (21 or 22) with the compartments (4, 8) for the cathodes (11, 12).

4. Apparatus according to one or more of claims 1 to 3, **characterised in that** opening into the compartments (4, 8) equipped with the cathodes (11, 12) are lines (23, 23' or 25, 25') via which argon can be admitted into these compartments (4, 8) and additional lines (24, 24'), via which a reactive gas can be admitted, open into a third compartment (6) arranged between the two cathode compartments (4, 8).

5. Apparatus according to one or more of claims 1 to 4, **characterised in that** the compartments (5, 6, 7) arranged between the two compartments (4, 8) provided with cathodes (11, 12) are each connected to vacuum pumps (16, 17, 18).

6. Apparatus for coating a substrate (30), comprising an alternating current source (43) which is connected to two cathodes (58, 59) which enclose magnets and which cooperate electrically with the targets, the one pole of the alternating current source (43) being connected to the one cathode (58) and the other pole to the other cathode (59) via power supply lines (41, 42), **characterised in that** each of the two cathodes (58, 59) is provided in its own compartment (32', 40) of a large number of adjacent compartments (32 to 40') which together form a vacuum chamber (31) and are interconnected via a passageway (60), the two compartments (32', 40) having the cathodes (58, 59) connected to the alternating current source (43) being arranged separated from each other by one or more compartments (33 to 39 and 33' to 38'), at least some of which are each equipped with a sputter cathode (61 to 66).

7. Apparatus according to claim 6, **characterised in that** the first and the last compartments (32' or 40) of compartments (32' to 40') located beside one another in a row are each equipped with a cathode (58 or 59) and, additionally, opening into the two compartments (32', 40) are gas feed lines (51, 51' or 53, 53') via which a process gas can be led into these compartments (32', 40).

8. Apparatus according to claim 6, **characterised in that** the passageway (60) for the conveyance of the substrates (30) through the cathode stations (32' and 40), the cathodes of which are connected to the alternating current source (43), is provided partially via pipes or shafts (54, 55, etc.) which are arranged in alignment and guided in a sealing manner through individual walls (49, 56 or 50, 57) separating the compartments from each other, the compartments (33 or 40') through which the pipes or shafts (54, 55, ...) protrude corresponding with the compartments (32', 40) for the cathodes (58, 59) via apertures or openings (47, 48, etc.) in the partition walls (49, 50, etc.).

9. Apparatus according to claims 1 to 3, **characterised in that** beside the compartments (32', 40) for the two cathodes (58, 59) connected to the generator (43), additional compartments (33' to 38') are provided in which sputter cathodes (61 to 66) are arranged which are connected to a second current source, these compartments (33' to 38') having cathodes (61 to 66) being open towards the passageway (60) for the substrate (30) and the substrate (30), as it is conveyed through the passageway (60), reaching the sphere of influence of all of these cathodes (61 to 66).

## Revendications

1. Dispositif pour le revêtement d'un substrat (2), en particulier au moyen de couches non conductrices de cibles électriquement conductrices en atmosphère réactive (par exemple oxydante), constituée par une source de courant alternatif (15) qui est reliée par deux cathodes (11, 12) incorporant des aimants qui coopèrent électriquement avec les cibles, qui sont atomisées et dont les particules atomisées se déposent sur le substrat (2), dans lequel l'un des pôles de la source de courant alternatif (15) est raccordé à une cathode (11) et l'autre pôle à l'autre cathode (12) par le biais de conduites d'alimentation (13, 14), **caractérisé en ce que** chacune des deux cathodes (11, 12) est prévue dans un compartiment propre (4, 8) d'une pluralité de compartiments (4 à 8) reliés entre eux par l'intermédiaire d'un passage (9), formant conjointement une chambre de vide (3), dans lequel les deux compartiments (4, 8) comportant les cathodes (11, 12) sont disposés directement côte à côte ou sont prévus séparés entre eux par un ou plusieurs compartiments (5, 6, 7).

2. Dispositif selon la revendication 1, **caractérisé en ce que** le premier et le dernier compartiment (4 ou 8) des compartiments (4 à 8) situés côte à côte dans une rangée sont respectivement munis d'une cathode (11 ou 12), dans lequel, dans les deux compartiments (4, 8), des conduites de gaz débouchent de façon supplémentaire, grâce auxquelles un gaz de procédé peut être introduit dans ces compartiments.

3. Dispositif selon la revendication 1, **caractérisé en ce que** le passage (9 ou 10) pour le transport des substrats (2) à travers les postes de cathodes (4 et 8) s'effectue partiellement par l'intermédiaire de tubes ou de cuves disposés en alignement (26, 27), qui sont agencés de façon hermétique par des parois (21, 28 ou 22, 29) séparées entre elles par différents compartiments, dans lequel les compartiments (5 ou 8) par lesquels passent les cuves ou les tubes (26, 27) correspondent, par l'intermédiaire de passages ou d'ouvertures (19 ou 20) dans les parois de séparation (21 ou 22), aux compartiments (4, 8) pour les cathodes (11, 12).

4. Dispositif selon l'une ou plusieurs des revendications 1 à 3, **caractérisé en ce que**, dans les compartiments (4, 8) équipés des cathodes (11, 12), débouchent les conduites (23, 23' ou 25, 25') par lesquelles de l'argon peut être introduit dans ces compartiments (4, 8), dans lequel, dans un troisième compartiment (6) disposé entre les deux compartiments de cathodes (4, 8), débouchent d'autres conduites (24, 24') par lesquelles peut être introduit un gaz réactif.

5. Dispositif selon l'une ou plusieurs des revendications 1 à 4, **caractérisé en ce que**, entre les deux compartiments (4, 8) munis de cathodes (11, 12), sont raccordés les compartiments (5, 6, 7) respectivement munis de pompes à vide (16, 17, 18).

6. Dispositif pour le revêtement d'un substrat (30) consistant en une source de courant alternatif (43) qui est raccordée par des cathodes (58, 59) incorporant deux aimants, qui coopèrent électriquement avec les cibles, dans lequel l'un des pôles de la source de courant alternatif (43) est raccordé à la cathode (58) et l'autre pôle est raccordé à l'autre cathode (59) par l'intermédiaire des conduites d'alimentation (41, 42), **caractérisé en ce que** chacune des deux cathodes (58, 59) est disposée dans un compartiment propre (32', 40) d'une pluralité de compartiments raccordés entre eux (32 à 40') par l'intermédiaire d'un passage (60) disposé de façon adjacente, conjointement avec une chambre de vide (31), dans lequel les deux compartiments (32', 40) présentant des cathodes (58, 59) raccordées à la source de courant continu (43) sont disposés de façon séparée entre eux par l'intermédiaire d'un ou de plusieurs compartiments (33 à 39 et 33' à 38') qui, au moins en partie, sont munis d'une cathode de pulvérisation (61 à 66).

7. Dispositif selon la revendication 6, **caractérisé en ce que** le premier et le dernier compartiment (32' ou 40) des compartiments (32' à 40') disposés côte à côte dans une rangée sont respectivement munis d'une cathode (58 ou 59), dans lequel, dans les deux compartiments (32', 40), débouchent de plus des conduites de gaz (51, 51' ou 53, 53') par lesquelles un gaz de procédé peut être introduit dans ces compartiments (32', 40).

8. Dispositif selon la revendication 6, **caractérisé en ce que** le passage (60) pour le transport des substrats (30) à travers les postes de cathodes (32' et 40), dont les cathodes sont raccordées à la source de courant alternatif (43), s'effectue partiellement par l'intermédiaire de tubes ou de cuves (54, 55, etc.) disposés en alignement, qui sont aménagés par des parois (49, 56 ou 50, 57, etc.) de séparation des différents compartiments entre eux, dans lequel les compartiments (33 ou 40') à travers lesquels font saillie les tubes ou cuves (54, 55, ...) correspondent, par l'intermédiaire de passages ou d'ouvertures (47, 48, etc.) dans les parois de séparation (49, 50, etc.), aux compartiments (32', 40) pour les cathodes (58, 59).

9. Dispositif selon l'une des revendications 1 à 3, **caractérisé en ce qu'**à côté des compartiments (32', 40) pour les deux cathodes (58, 59) raccordées au générateur (43), sont prévus d'autres compartiments (33' à 38'), dans lesquels sont agencées des cathodes de pulvérisation (61 à 66), qui sont raccordées à une seconde source de courant, dans lequel ces compartiments (33' à 38') présentant ces cathodes (61 à 66) sont ouverts pour le passage (60) pour le substrat (30), et le substrat (30), lors du transport à travers le passage (60), parvient dans la zone d'activité de toutes ces cathodes (61 à 66).
